# EUROPEAN PATENT APPLICATION

(11) **EP 4 718 155 A2**
(43) Date of publication of application: **01.04.2026**
(21) Application number: 25197235.2
(22) Date of filing: 21.08.2025
(51) Int. Cl.: G03F 1/36

(54) **MASK VARIABILITY REDUCTION THROUGH LOCALITY PRESERVING PATTERN HASHES**

(30) Priority: 26.09.2024 US 202418898390
(71) Applicant: Intel Corporation, Santa Clara, CA 95054 (US)
(72) Inventor: DHANANJAY VINJAMUR, Raghunathan, Portland, 97229 (US); HORSCH, Mark Andrew, Camas, 98607 (US)
(74) Representative: HGF

(57) **Abstract**

A method includes generating a hash comprising a plurality of values based on a geometric pattern within a window that represents a portion of a physical design for a semiconductor mask layer, the window including at least a portion of a polygon; determining a displacement value for a segment of the polygon based on the hash; and modifying a position of a segment of the polygon based on the displacement value.

## Description

### TECHNICAL FIELD

This disclosure relates in general to the field of computing systems and, more particularly, to mask variability reduction through locality preserving pattern hashes.

### BACKGROUND

Cutting-edge semiconductor manufacturing processes are terribly complex. Housed in billion-dollar factories and comprising hundreds of processing steps to yield a finished device, they are capable of reliably printing features as small as a few nanometers hundreds of billions of times across wafers that extend a foot in diameter. Developing a new semiconductor manufacturing process requires defining a set of design rules that establish constraints that a semiconductor device must follow to ensure manufacturability. Process development also involves developing optical proximity correction (OPC) recipes that adjust physical design features before they are printed on a mask to help counter feature distortions caused by various processing steps.

### BRIEF DESCRIPTION OF THE DRAWINGS

FIG. 1A illustrates the physical design of an exemplary planar transistor in accordance with any of the embodiments disclosed herein.
FIG. 1B illustrates an exemplary cross-section of the planar transistor of FIG. 1A taken along the line A-A ' in accordance with any of the embodiments disclosed herein.
FIGS. 2A-2F illustrate an exemplary photolithography process in accordance with any of the embodiments disclosed herein.
FIGS. 3A-3D illustrate differences between features printed on a mask and those processed on a wafer due to process distortion effects and the use of optical proximity correction to counter those effects in accordance with any of the embodiments disclosed herein.
FIG. 4 illustrates similar patterns and corresponding hashes in accordance with any of the embodiments disclosed herein.
FIG. 5 illustrates a sequence for predicting a portion of a mask in accordance with any of the embodiments disclosed herein.
FIG. 6 illustrates generation of a locality preserving hash comprising moments in accordance with any of the embodiments disclosed herein.
FIG. 7 illustrates point masses of polygons in accordance with any of the embodiments disclosed herein.
FIG. 8 illustrates generation of a locality preserving hash comprising feature measurements in accordance with any of the embodiments disclosed herein.
FIG. 9 illustrates example feature measurements in accordance with any of the embodiments disclosed herein.
FIG. 10 illustrates architectures for predicting mask displacements in accordance with any of the embodiments disclosed herein.
FIG. 11 illustrates a machine learning architecture for reducing mask variability through locality preserving hashes in accordance with any of the embodiments disclosed herein.
FIG. 12 illustrates a flow for pre-biasing an optical proximity correction flow using locality preserving hashes in accordance with any of the embodiments disclosed herein.
FIG. 13 illustrates a flow for modifying location of a polygon segment using a locality preserving hash in accordance with any of the embodiments disclosed herein.
FIG. 14 illustrates a computing system in accordance with any of the embodiments disclosed herein.

Like reference numbers and designations in the various drawings indicate like elements.

### DESCRIPTION OF EXAMPLE EMBODIMENTS

Semiconductor manufacturing has become increasingly complex over the years. Since the turn of the century, the minimum feature size has shrunk by over an order of magnitude as the industry has progressed from the 130 nanometer (nm) to 2 nm technology nodes. In semiconductor manufacturing, a technology node (also referred to as a process node) may refer to a specific semiconductor manufacturing process. A technology node historically referred to a semiconductor feature size (e.g., channel length) measured in nanometers (nm), although recently some technology node names have become decoupled from specific feature sizes and instead generally refer to relative size, performance, and/or power consumption of integrated circuits built using the technology node.

At the same time, processor complexity has dramatically increased. Current flagship products have transistor counts that well exceed 10 billion. To handle these reduced feature sizes and increased chip complexities, companies must invest billions of dollars and years of research to build state-of-the-art fabrication facilities. Research and development costs are driven ever-upward by the rising cost of increasingly sophisticated equipment needed for advanced processes. The industry has taken steps to decrease per-transistor manufacturing costs (for example, by moving to larger wafers), but the overall trend has been for each process generation to cost more than the last. With up to hundreds of individual dies on wafers that span a foot in diameter, the total number of transistors that can be printed on a wafer is on the order of one trillion. Developing high-volume manufacturing processes that can reliably manufacture transistors at such an extreme scale presents considerable challenges.

Reference is now made to the drawings, wherein similar or same numbers may be used to designate same or similar parts in different figures. The use of similar or same numbers in different figures does not mean all figures including similar or same numbers constitute a single or same embodiment.

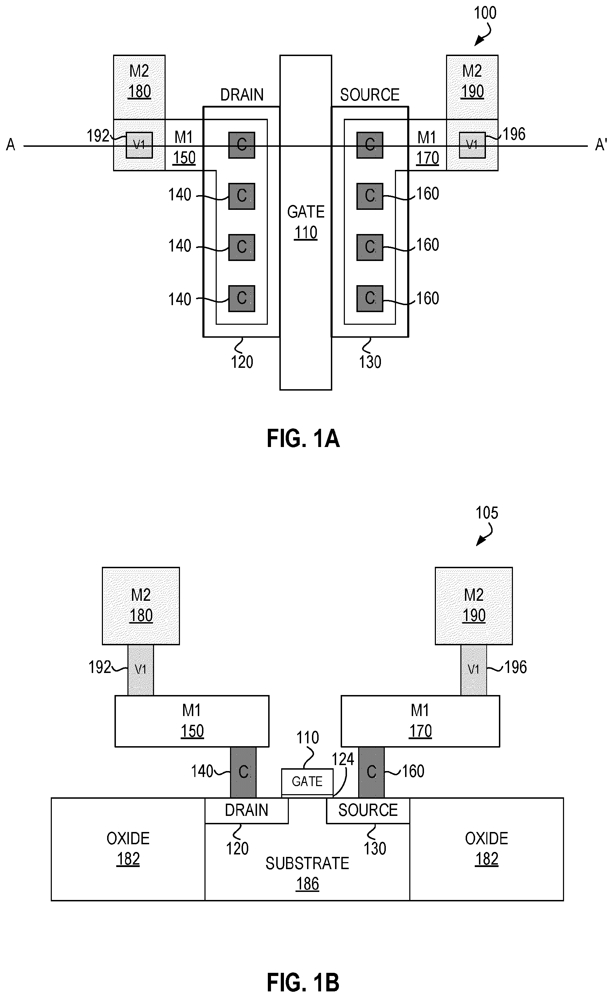

Turning now to FIGS. 1-3, an overview of various aspects of semiconductor device manufacturing is presented. FIG. 1A illustrates the physical design of an exemplary planar transistor. As will be discussed in greater detail below, the physical design of a transistor is used to generate the masks that will be used during manufacturing to print the features on a wafer needed to implement a particular design. The physical design is typically a set of polygons drawn at various layers, such as a gate layer, contact layer, and a metal (e.g., M1) layer.

Transistor 100 is a field-effect-transistor (FET), the transistor type that comprises the bulk of transistors used in modern semiconductor devices. Transistor 100 comprises gate 110, drain 120, and source 130 regions. The gate region in a FET can be thought of as an "on-off" switch that controls the flow of current between drain and source regions. When gate 110 is "off", there is no (or little) current flowing through a channel region that connects drain 120 to source 130 and when gate 110 is "on", current readily flows through the channel region. Transistor 100 is connected to other transistors by a set of interconnect layers stacked vertically on top of transistor 100. Contacts 140 connect drain 120 to segment 150 of a first metal layer (M1), and contacts 160 connect source 130 to M1 segment 170. M1 segments 150 and 170 are in turn connected to a second metal layer (M2) segments 180 and 190 by a first layer of "vias" (V1) 192 and 196, respectively. In general, metal layer thickness increases as one moves up the interconnect stack, with thinner lower-level metals being generally used for the local routing of signals and thicker upper-level metals being used for global signal routing and power/ground planes. For simplicity, FIG. 1A shows only two levels of metal. Current semiconductor manufacturing processing may have upwards of ten or more layers of metal interconnects.

FIG. 1B illustrates an exemplary cross-section of the planar transistor of FIG. 1A taken along the line A-A . Cross-section 105 shows gate 110 separated from drain 120 and source 130 regions by high-k dielectric layer 124, which electrically insulates gate 110 from drain 120 and source 130. Transistor 100 is in substrate region 186 and is insulated from adjacent transistors by oxide regions 182. The planar transistor illustrated in FIGS. 1A and 1B is just one type of transistor topography, the planar nature of the transistor reflecting that the gate, source, and drain regions are located on or are adjacent to a relatively planar surface. Another type of transistor topography is the non-planar transistor topography used in FinFETS, which are used extensively in cutting-edge manufacturing processes. FinFETS are field-effect transistors that operate under the same general principle as planar FET transistors - a gate controls the flow of current between drain and source region - with the variation that the gate wraps around a set of fins that extend vertically upwards from the wafer surface.

Essential to semiconductor manufacturing is the process of photolithography, by which patterns are transferred from a mask onto a wafer. As previously mentioned, masks are used to define the shape and location of various features to be patterned on a wafer for a given process layer. For example, one mask defines where oxide regions are located, another mask defines where high-k dielectrics will be located, another mask defines locations of source and drain regions, and yet another mask will define where contacts will be placed. Additional masks may be used to define each metal layer and intervening via layers.

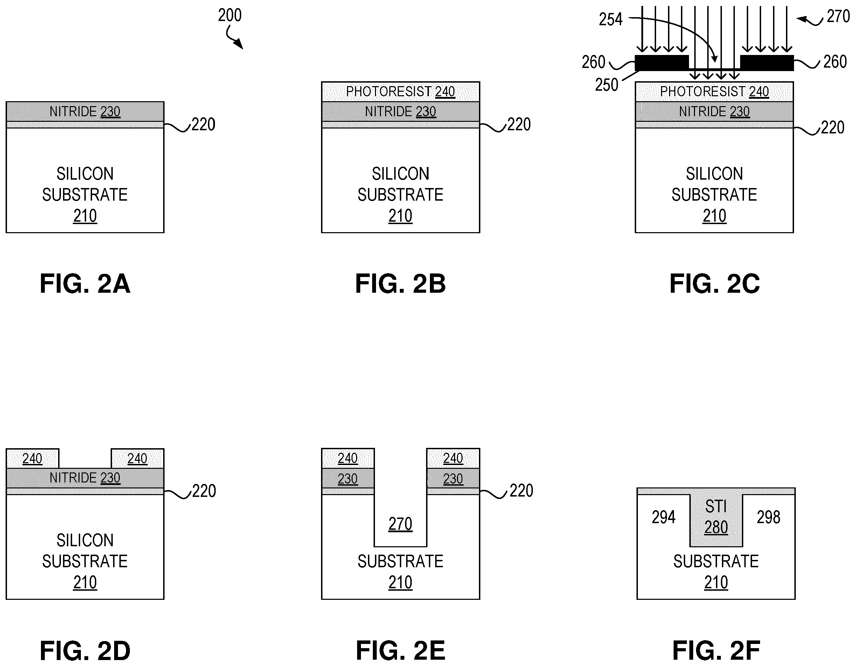

FIGS. 2A-2F illustrate an exemplary photolithography process. Process 200 illustrates how the oxide regions 182 in FIG. 1B can be defined using photolithography. In FIG. 2A, a thin silicon dioxide layer 220 is thermally grown across the top of silicon substrate 210 of a wafer. Silicon nitride layer 230, a protective layer, is deposited on top of silicon dioxide layer 220. In FIG. 2B, photoresist 240 is deposited on top of nitride layer 230. A photoresist is a material whose reactance to an etchant or solvent increases (if a positive photoresist) or decreases (negative photoresist) upon exposure to light. In process 200, photoresist 240 is a positive photoresist. In FIG. 2C, mask 250 with patterns 260 is positioned over the wafer and exposed to light. The light passes through transparent region 254 of mask 250 and exposes photoresist 240. Patterns 260 are opaque to the light and the photoresist regions under patterns 260 are not exposed. In FIG. 2D, photoresist 240 is chemically developed and the exposed regions are dissolved. The remaining portions of photoresist 240 can now act as an on-wafer mask to allow for selective processing of the wafer. In FIG. 2E, the wafer is subjected to an etch step that removes a portion of the silicon nitride layer 230, silicon dioxide layer 220, and substrate 210 to create trench 270. In FIG. 2F, the photoresist and nitride layers are removed, and trench 270 is filled with silicon dioxide to create shallow trench isolation (STI) region 280 that serve to keep transistors formed in regions 294 and 298 electrically isolated from each other.

As masks are the means by which features are realized in semiconductor devices, any semiconductor device design must ultimately be reduced to a physical design, the level of design abstraction from which masks are generated. The physical design of a transistor (such as FIG. 1A), circuit, or processor to be manufactured is often referred to as a "layout." Electronic design automation (EDA) tools allow processor architects and circuit designers to design at levels of abstraction above the physical design level. Architects typically define their designs using a hardware design language (HDL), such as VHDL or Verilog. Once they have verified that their designs perform as desired, a physical design can be generated automatically using a library of standard layout cells. Circuit designers often seek performance or functionality not available using standard cells and often enter their designs into a schematic capture tool. Once their custom designs are finalized, the circuit schematics are handed off to layout designers who manually craft the custom physical designs.

Regardless of whether a physical design is generated automatically or manually it must conform to a set of layout design rules established for a manufacturing process. Design rules are constraints that a physical design must follow to ensure manufacturability with an acceptable yield. The rules may specify enough margin such that variability inherent in the manufacturing process will not result in chip failure at an unsuitably high rate. A design rule may specify constraints within a single layer or within multiple layers. As examples, a design rule may specify a minimum width of a feature ("gate length ≥10 nm"), a minimum distance between two features (e.g., "space between metal-1 traces ≥ 20 nm"), an enclosure rule specifying that a feature (e.g., a contact or via) is covered (e.g., by a metal layer) (e.g., source/drain diffusion enclosure of a contact ≥ 16 nm), a minimum area for a feature, antenna rules specifying ratios of areas of multiple layers, or other suitable rules.

Once a physical design is clear of design rule violations and has passed other design validation checks, it is passed to the mask generation phase of an EDA flow. The mask generation phase is far from trivial due to the discrepancy between the wavelength of the light (e.g., λ = 193 nm or 13.5 nm) that has been used since the 90 nm technology node and the minimum feature sizes (e.g., 3 nm) used in the current processes. The minimum feature size that can be printed clearly in a photolithographic process is limited by the wavelength of the light source used and the semiconductor industry has developed resolution enhancement technologies (RET) to allow for the printing of features well below the 193 nm light source wavelength. A first set of RET techniques works to increase resolution and/or depth of focus, and a second set compensates for distortion effect due to printing features with a wavelength larger than minimum feature sizes as well as those inherent in deposition, etching, and other process steps. The first set includes techniques such as phase-shift masks and double-patterning, and the second set includes optical proximity correction (OPC).

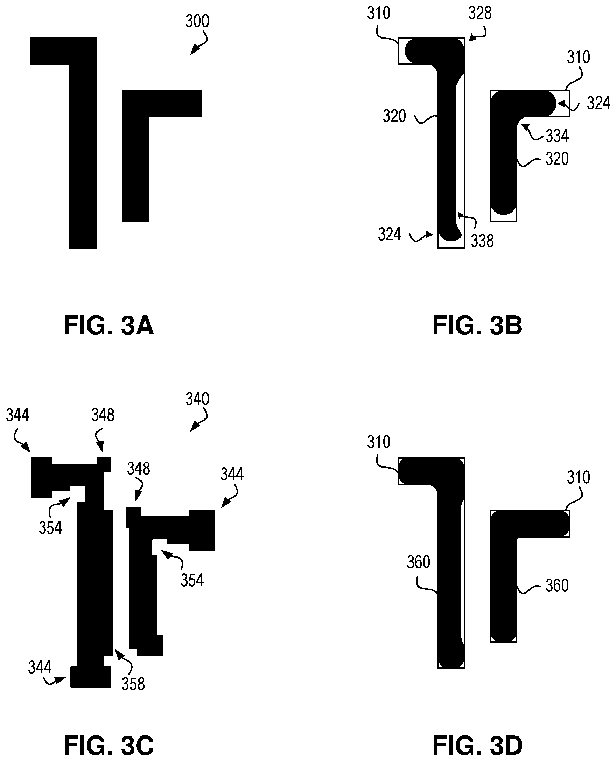

FIGS. 3A-3D illustrate differences between features printed on a mask and those processed on a wafer due to process distortion effects and the use of optical proximity correction to counter those effects. FIG. 3A illustrates two gate polygons 300 in a physical design before being subjected to an OPC process. FIG. 3B illustrates a simplified view of how polygons 300 may appear as processed on a wafer. Outlines 310 represent the boundaries of polygons 300 and shapes 320 represent the corresponding asprocessed features. It can be seen that ends 324 and exterior corners 328 of shapes 320 are rounded off, interior corners 334 are filled in, and segment 338 narrowed due to a nearby feature. FIG. 3C illustrates exemplary modified polygons 340 generated by subjecting polygons 300 to an OPC process. Modified polygons 340 are much more complex than original polygons 300. Modified polygons 340 include "dog-bone" features 344 that compensate for end-rounding, "ear" features 348 that compensate for exterior corner-rounding, "mouse-bite" features 354 that compensate for interior corner-rounding, and thickening features 358 that compensate for the presence of nearby features. FIG. 3D illustrates a simplified view of how modified polygons 340 may appear on a wafer after processing. Outlines 310 again represent the boundaries of original polygons 300. As can be seen, modification of polygons 300 by the OPC process results in printed shapes 360 that are closer to the shape and size of original polygons 300. The ends and corners of shapes 360 are less rounded off, the interior corners are less filled in, and the impact of nearby neighbors is diminished.

While OPC generation (and other RET techniques) have allowed minimal features to scale with technology node as the wavelength of the photolithographic light source has remained constant, it does not come without its costs. OPC generation is computationally intensive. OPC recipes can be based on physical models of various processing steps (photolithography, diffusion, etch, deposition, etc.), or be rule-based models that generate OPC features based on individual physical design feature characteristics (width, length, shape, nearest-neighbor characteristics) without relying on the physics of the underlying process steps. The application of model-based OPC recipes to a complete physical design may involve the application of physical models to over 10 billion shapes at the gate layer alone and to billions of additional shapes on other layers. Further, the generation of rule-based OPC models, which may save some of the computational complexity of model-based OPC generation, can be a complex affair. Generation of rule-based OPC recipes can be based on trial-and-error due to a lack of full understanding of the complex physics and chemistries at play in the development of cutting-edge processing technologies. This trial-and-error can comprise iteratively manufacturing features with manyvariations of candidate OPC recipes and seeing which recipes produce the best results.

In practice, OPC generated mask patterns are subject to numerical artifacts since the output of the OPC process is computed via numerical simulation. These artifacts may lead to the generation of slightly different proposed mask patterns by the OPC process for an identically drawn pattern at different locations of the physical design on the die. This variability increases the difficulty of mask metrology (e.g., it may complicate a calibration process for the production of the mask, it may make root causing errors more difficult, etc.) and complicate the finding of yield limiter sites. In addition, re-correcting the same site via OPC multiple times is computationally inefficient.

In various embodiments, geometric features of the patterns in the physical design are analyzed to form locality preserving hashes (e.g., feature sets). The locality preserving hashes have properties such that patterns that have similar geometries have locality preserving hashes that are similar too. Thus, the degree of change to the geometry of the pattern may correlate with the degree of change to the hash (unlike common hash algorithms in which a one bit change to the input data may result in a significant change to the hash value). Mask details of one or more good designs may be captured along with the hashes. If the same pattern occurs multiple times, a single mask solution may be selected for the pattern. In various embodiments, a cache comprising a library of previously known good mask solutions and corresponding hashes is built and used to predict a mask outcome given the drawn layout in an area of the physical design. In some embodiments, the hashes and mask patterns of the good design(s) may be used to train a machine learning (ML) model that is then used to predict localized masks given the geometric features within regions of interest in a physical design. In this manner, the ML model may mimic an OPC simulation. In various instances, the predictions may be incorporated into a broader OPC process and used as a starting point (e.g., a pre-bias) to generate modified polygons in the physical design which are then simulated to determine whether the design is acceptable (and then the modified polygons may be further refined if necessary).

In various embodiments, the locality preserving hashes are based on modified image moment generation functions (e.g., modified Hu-moments, modified Chebyshev moments, etc.). In some embodiments, the locality preserving hashes are based on collections of geometric feature measurements. Both approaches capture characteristics of the layout geometry in a specific context (called a window) to generate the hashes.

Various embodiments described herein may provide one or more advantages, such as consistency in the patterning leading to consistency in the die, faster computation for OPC, faster physics simulations, faster searching of patterns via a scalable database of patterns (e.g., a vector database may be used to store the hashes and perform searches for similar patterns to facilitate pattern clustering and enable scalable fast pattern analytics), and predictive planning capabilities based on a physical design and prior designs (e.g., based on yield and defect metrology).

In various embodiments, the computing resources used in various embodiments to predict mask configurations may scale with the number of vertices of the drawn polygons (and thus may scale linearly or sub-linearly) rather than area (as would be the case if the layout were interpreted as a pixelated image for analysis), thus enabling an increase in the size of the windows used for hash generation. Increasing the window size for hash generation allows for more pattern distinguishing nuance to be captured for better predictive performance of an ML model.

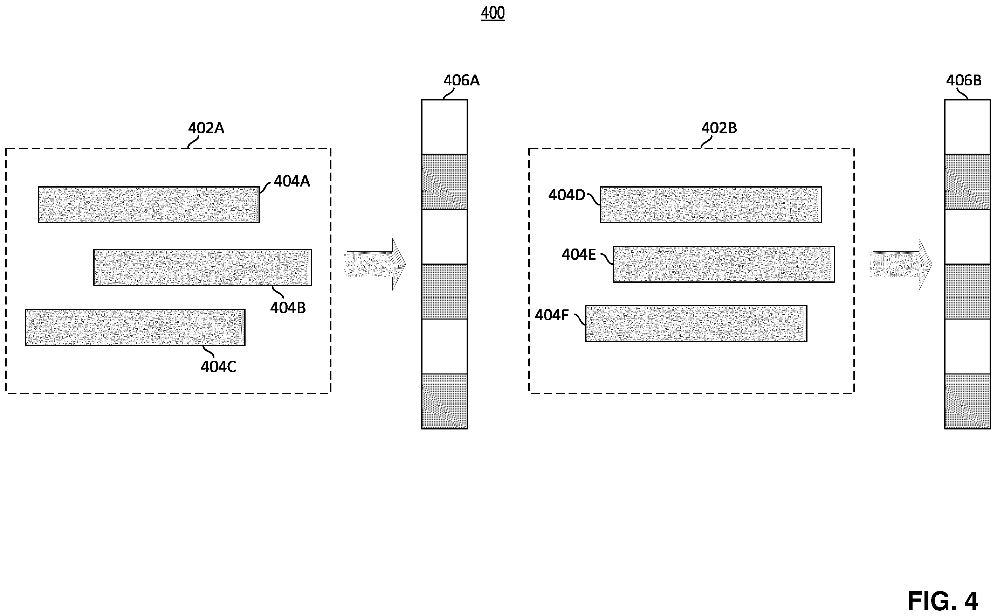

FIG. 4 illustrates similar patterns and corresponding locality preserving hashes in accordance with any of the embodiments disclosed herein. A first window 402A includes a first pattern of drawn polygons 404A, 404B, and 404C and a second window 402B includes a second pattern of drawn polygons 404D, 404E, 404F.

A first locality preserving hash 406A may be generated based on the first pattern of the first window 402A. The hash 406A may comprise a vector comprising a plurality of values that are based on the geometry of the pattern of the first window 402A (and thus the hash preserves the locality of the pattern).

A second locality preserving hash 406B may be generated based on the second pattern of the second window 402B. The hash 406B may comprise a plurality of values that are based on the geometry of the pattern of the second window 402B (and thus the hash preserves the locality of the pattern).

Since the hashes 406 preserve the locality of their respective patterns, if the drawn patterns are the same, then the hashes 406 will be the same. Moreover, if the drawn patterns are slightly different, then the hashes 406 will be slightly different. That is, the hashes 406 will be more similar to each other than if the patterns were significantly different.

The hash 406A may be associated with one or more attribute values for the pattern. For example, the hash 406A could be associated with a yield probability (e.g., how likely the pattern is to be successfully manufactured), a result of a physics simulation on the pattern, or an OPC model prediction (e.g., how far a segment of a polygon of the pattern should be displaced for the mask for the polygon). If the hash 406A is the same as the hash 406B, then the one or more attribute values associated with the hash 406A may be considered to be the same for the hash 406B (and by association the pattern of second window 402B). For example, the first pattern may be present in a first known good design and the second pattern may be present in a second design and may be identical to the first pattern. Accordingly, the one or more attribute values (e.g., the OPC based final mask outcome) may be reused for the second pattern.

If the hash 406A is not the same as the hash 406B, but is relatively close, then the one or more attribute values for the hash 406B (and pattern of second window 402B) may be interpolated based on the one or more attribute values associated with the hash 406A and the distance between the hash 406A and 406B (where the distance represents the degree of similarity between the first pattern and the second pattern). In general, an attribute value *a₂* for hash 406B (e.g., *v₂*) may be deduced from hash 406A (e.g., *v₁*) through a pre-trained ML function f(.) such that *a₂ =* f(*v₂*). The function f(.) is trained to get good quality interpolation when small ∥*v₂-v₁*∥ implies small |*a₂-a₁*|, where *a₁* is the attribute value for hash 406A. That is, nearness in layout space implies nearness in the attribute space.

A function f(*v*) may be trained to predict multiple attributes simultaneously with good quality interpolation if the attributes being trained for have a nearness property as described above.

In this manner, the patterns may be transformed from a variable dimension space (as the patterns may have any suitable number of polygons) into a finite dimensional space (e.g., hashes 406 may each have the same number of elements) such that patterns close in pattern space are also close in the hash space. Thus, a hash function may map geometric input from a variable dimension space (e.g., a layout database format such as an OASIS layout) into a finite dimensional space that preserves mask similarity.

In some instances, the one or more attribute values may be interpolated based on one or more additional hashes that are relatively similar to the hash 406B (and their associated one or more attribute values). For example, if a hash 406B is between the hash 406A and a third hash 406C, then the one or more attribute values for the hash 406B may be between the one or more attribute values for the hash 406A and the one or more attribute values for the hash 406C.

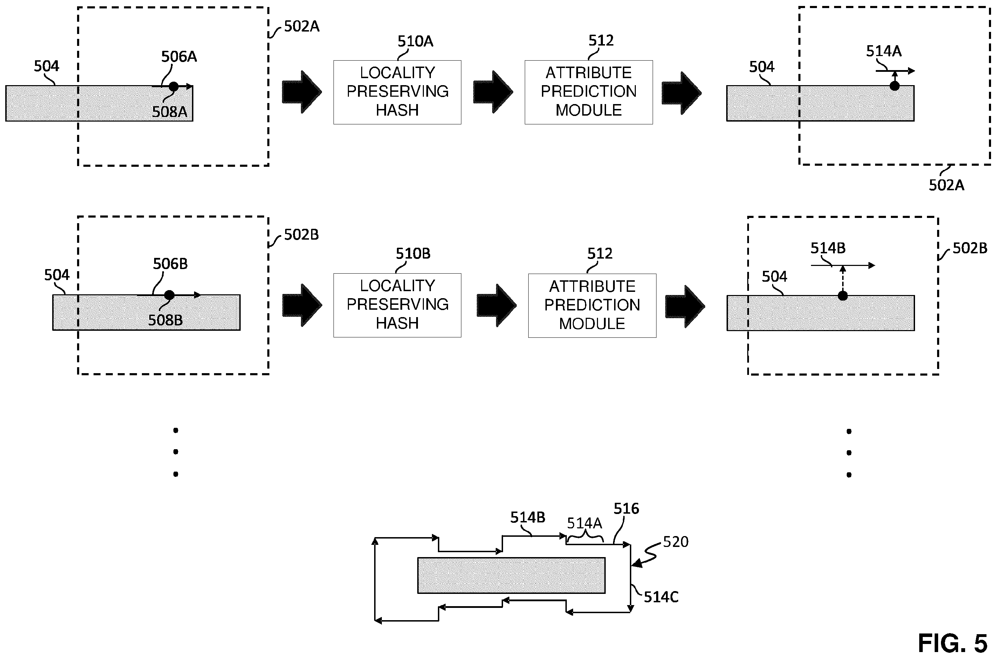

FIG. 5 illustrates a sequence for generating a mask for a polygon in accordance with any of the embodiments disclosed herein. In a first phase, a window 502A is defined around a target segment 506A of a drawn polygon 504 in a physical design. In the embodiment depicted, the window 502A is centered around an anchor point 508A of the segment 506A. The anchor point may be placed at the point of interest for pattern capture. This is often set to the midpoint of the segment under consideration, but need not necessarily be so (e.g., it could be placed at a different point of the segment). In various embodiments, the window is centered at the anchor-point.

Although not shown, in addition to the drawn polygon that includes the target segment, the window 502A (or other windows used in the sequence) may include any other drawn polygons (or portions thereof) in any suitable arrangement around the drawn polygon (collectively the geometric arrangement of drawn polygons and open space within the window may be termed a pattern). Thus, a pattern may include one or more layout features of a semiconductor chip design, such as a geometric design pattern for an area defined in a layout database file. Any suitable database file format may be used for the layout database file, such as Graphic Data System II (GDS II), Open Artwork System Interchange Standard (OASIS), or other suitable format. A layout database file may provide a representation of a semiconductor chip in terms of planar geometric shapes (e.g., polygons) corresponding to patterns of, e.g., metal, oxide, or semiconductor layers of the chip. A layout database file may represent the physical placement of various devices on the chip. Such a file may specify the presence or absence of various features on different mask layers for masks used to produce the chip.

Thus, in a particular embodiment, each pattern may correspond to one or more particular geometric polygons (or portions thereof) within an area (e.g., a window) represented by a portion of a layout database file. A pattern may be unique within the chip or may be repeated any number of times across the chip (e.g., dozens of times, hundreds of times, thousands of times, or more). In some embodiments, a chip may include tens of thousands of unique patterns. In other embodiments, a chip may include additional or fewer unique patterns.

In various embodiments, the windows used (e.g., 502A, 502B, etc.) may have any suitable shape (e.g., square, other rectangle, circle, or other shape) or size. In various embodiments, the window size is selected (e.g., based on simulation results) so as to be large enough to achieve sufficient amount of variety in the patterns. A window size that is too small may result in a variety of different mask patterns being associated with identical drawn layout patterns. This is typically because pattern variety is present outside of the window in which the pattern is captured. Minimization or elimination of this ambiguity may be achieved through the choice of a larger window.

The pattern within the window 502A is analyzed and a locality preserving hash 510A is generated based on the geometry of the pattern. The hash 510A is generated in a manner that preserves various geometric features of the pattern and/or information based thereon. The hash 510A is then used by attribute prediction module 512 to determine an attribute for the pattern. In this instance, the attribute is a displacement of the segment 506A that includes the anchor point 508A. This displacement represents a distance that the segment 506A is to be moved from its originally drawn location (e.g., either outward or inward) in order to form a modified segment 514A of a modified polygon (e.g., that is to be used for a mask to manufacture a feature that more closely matches the drawn polygon as described above).

The sequence then moves to a second phase, in which a window 502B is defined around another target segment 506B of the drawn polygon 504. In the embodiment depicted, the window 502B is centered around an anchor point 508B of the segment 506B. The pattern within the window 502B is analyzed and a locality preserving hash 510B is generated based on the geometry of the pattern. The hash 510B is then used by attribute prediction module 512 to determine an attribute for the pattern of window 502B. Again, the attribute is a displacement of the segment 506B that includes the anchor point 508B. This displacement represents a distance that the segment 506B is to be moved from its drawn location in order to form a modified segment 514B of the modified polygon (e.g., a mask polygon).

The sequence continues and positions for other segments of the drawn polygon 504 are determined in a similar fashion (e.g., by cycling through regularly distributed anchor points). The determined positions collectively form a modified polygon 520. As depicted, the modified polygon 520 includes modified segments 514A and 514B (modified segment 514A may be concatenated with a segment that has a length equal to the displacement of the modified segment 514C to form segment 516) as well as various other modified segments.

Other polygons of the same layer in the physical design may be analyzed and modified in a similar fashion to produce a design for a mask layer that has less variation than a typical OPC generated mask layer would, since similarly drawn polygons will yield the same modified polygons in the output.

Various example methods by which the locality preserving hashes may be generated are now described.

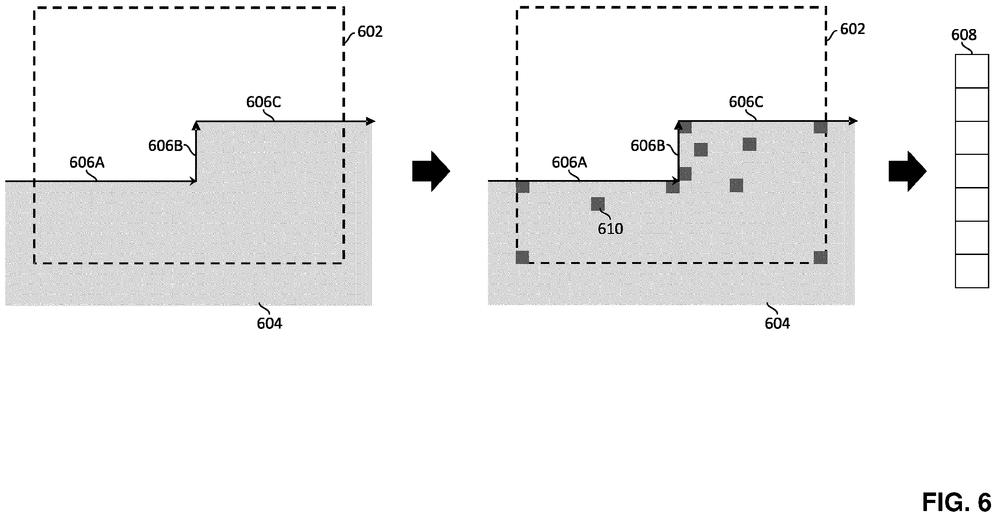

FIG. 6 illustrates generation of a locality preserving hash 608 comprising moments (e.g., image moments based on point masses) in accordance with any of the embodiments disclosed herein. In this embodiment, a window 602 is defined around a portion of a drawn polygon 604. In this embodiment, only a portion of the polygon 604 (bounded in part by edges 606A, 606B, 606C) is depicted.

In this embodiment, only a portion of the target polygon 604 is within the window 602. In other embodiments, an entire target polygon 604 may be within the window. Although not depicted, the window may include one or more other drawn polygons or portions thereof. In some instances (similar to the embodiment described above), the window may be centered about or otherwise encompass an anchor point on a segment of an edge (e.g., 606B).

In conjunction with the definition of the window 602, a plurality of point masses 610 may be assigned to represent the polygons within the window. Point masses may be used to represent the mass of a polygon in a manner that simplifies further analysis of the geometry of the polygon (e.g., using the point masses scales much better than calculating moments using a pixelated window). In some instances, a point mass may concentrate a mass from many different points (also referred to as pixels) of a polygon into a single point (where each point of a window is treated as having a unit of mass if the point is part of a polygon and as having no mass if the point is not part of a polygon). Point masses 610 may be proportional to the lengths of the edges 606 (and/or segments of the window edges that provide bounds for the polygon).

A moment generation function may be used to generate moments for the window based on the point masses within the window. A moment generation function may capture statistical characteristics, referred to as moments, of the pattern within the window. In general, a moment is a particular weighted average (moment) of the pixel intensities (e.g., masses in this case) of an image (or a function of such moments) that may be illustrative of the shape or distribution of the image's pixel intensities. In various embodiments herein, moments are calculated based on the point masses (which effectively aggregate pixel intensities within the window) rather than individual pixels within the window (as is commonly done with image moments), thus significantly speeding up calculation of the moments. Thus, a moment may be a weighted average of point masses and each moment in the same hash may be a different weighted average of the point masses of the pattern.

The locality preserving hash 608 may comprise any number of these moments calculated from the point masses of the window 602. A series of moments is used as a hash of the geometry of the window that uniquely identifies the geometry. Small changes to the geometry will yield a hash that is only slightly changed from the hash of the original geometry.

Any suitable moments may be calculated. For example, a first moment may comprise a centroid of the pattern (e.g., a center of mass). As another example, a second moment may be a moment of inertia. In various embodiments, a plurality of higher order moments are included in the hash 608 (e.g., a sufficient number of moments to adequately distinguish the patterns). For example, when a Hu-transform is used to generate the moments, six or seven (or other suitable number of) higher order moments may be calculated. As another example, when a Chebyshev moment function is used, sixteen higher order moments (or other suitable number of moments) may be used in the hash 608.

In one embodiment, a Hu-transform may be used to generate the moments (e.g., the Hu-moments of the point masses may be used as the hash). In another embodiment, a Chebyshev moment function may be used to generate the moments. Any other suitable family of moments may be used to generate the moments of the locality preserving hashes 608, such as complex moments, rotational moments, geometric moments, orthogonal moments, continuous moments (e.g., Legendre moments, Zernike Moments, Pseudo-Zernike moments, generalized pseudo-Zernike moments, Chebychev-Fourier moments), discrete moments (e.g., Tchebichef moments, Krawtchouk moments, Racah moments, dual Hahn moments), or other suitable moments.

This method of pattern capturing based on moment functions scales with the number of vertices of the polygons in a window rather than with area of the polygons (as may be typical in general image processing techniques).

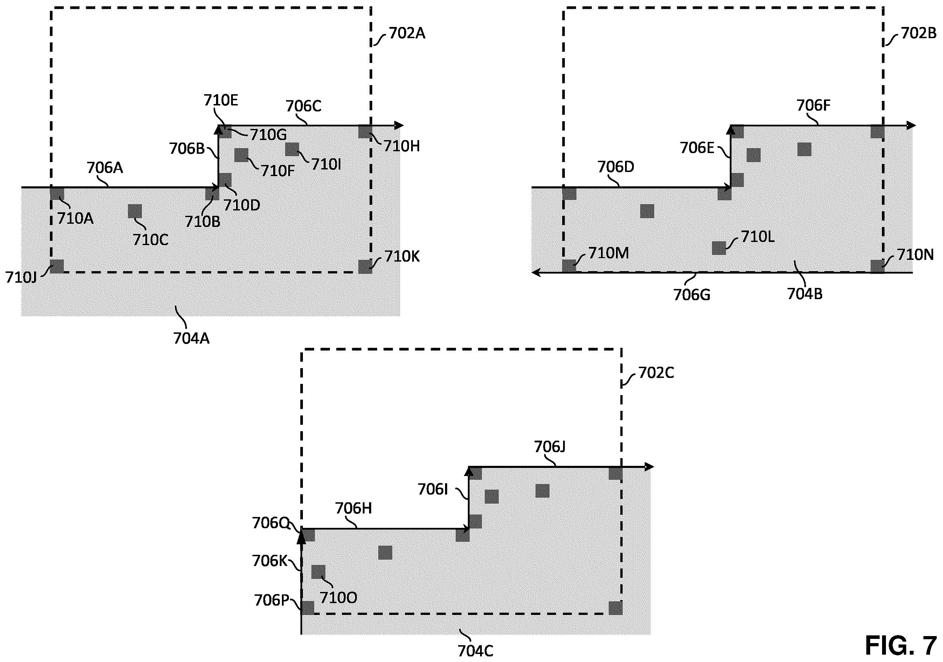

FIG. 7 illustrates configurations of point masses in accordance with any of the embodiments disclosed herein. Various embodiments may be able to distinguish nuances in the boundaries of the pattern capture windows. For example, a sectioned edge of a polygon may be distinguished between an edge touching the end of the capture window based on positioning of the point masses. The construction of the point masses may result in hashes that distinguish between such differences.

In FIG. 7, polygon 704A is bounded in part by edges 706A, 706B, and 706C. The polygon 704A extends past the window 702A on the right, left, and bottom. Polygon 704B is bounded in part by edges 706D, 706E, 706F and 706G. The polygon 704B extends past the window 702B on the right and the left, but is bounded by edge 706G on the bottom and does not extend past the window 702B. Polygon 704C is bounded in part by edges 706H, 7061, 706J, and 706K. The polygon extends past the window 702C on the right and the bottom, but is bounded by edge 706K on the left and does not extend past the window 702C.

Point masses may be placed at salient features of the polygons based on knowledge of the drawn layout (e.g., the locations of edges and vertices of drawn polygons). For example, a point mass may be placed at each intersection of two edges 706 of a polygon and at each intersection of an edge 706 and a boundary of a window 702. In some instances, additional point masses may be placed to allow for determination of where a drawn polygon exists (vs. non-polygon areas).

When the drawn polygon 704 is bounded by an edge, then one or more additional point masses may be placed inside the edge and in between the point masses on the edge. This may allow differentiation between polygons that extend past an edge of a window and polygons that are bounded by an edge at or near a boundary of a window 702. For example, a single point mass may be placed in the center of the two point masses on the edge and offset away from the edge on a portion of the polygon within the window. As an example, point masses 710A and 710B are placed on edge 706A and point mass 710C is placed in the middle of these point masses, but is offset downwards from the edge 706A. As another example, point mass 710D and 710E are placed on edge 706B and point mass 710F is placed in the middle of these point masses, but is offset to the right from edge 706B. As another example, point masses 710G (which may be placed in the same location as point mass 710E) and 710H are placed on edge 706C and point mass 7101 is placed in the middle of these point masses, but is offset downwards from edge 706C. Because the polygon extends past the left boundary of the window 702A (since no edge is present on the left within the window), an additional point mass is not placed between point masses 710A and 710J. Similarly, because the polygon extends past the bottom boundary of the window 702A (as no edge is present within the window), an additional point mass is not placed between point masses 710J and 710K. Furthermore, because the polygon extends past the right boundary of the window 702A (as no edge is present within the window), an additional point mass is not placed between point masses 710H and 710K.

Contrarily, in window702B, an edge 706G of the polygon is proximate the bottom boundary of the window 702B (such that the polygon 704B does not extend past the bottom boundary of the window 702B) and so an additional point mass 710L is added between the point masses 710M and 710N (and offset up from the edge 706G) that are on the edge 706G (at the bottom corners of the window 702B).

Similarly, in window 702C, an edge 706K is proximate the left boundary of the window 702C (such that the polygon 704C does not extend past the left boundary of the window 702C) and so an additional point mass 7100 is placed between the point masses 710P and 710Q that are on the edge 706K (and offset to the right of edge 706K).

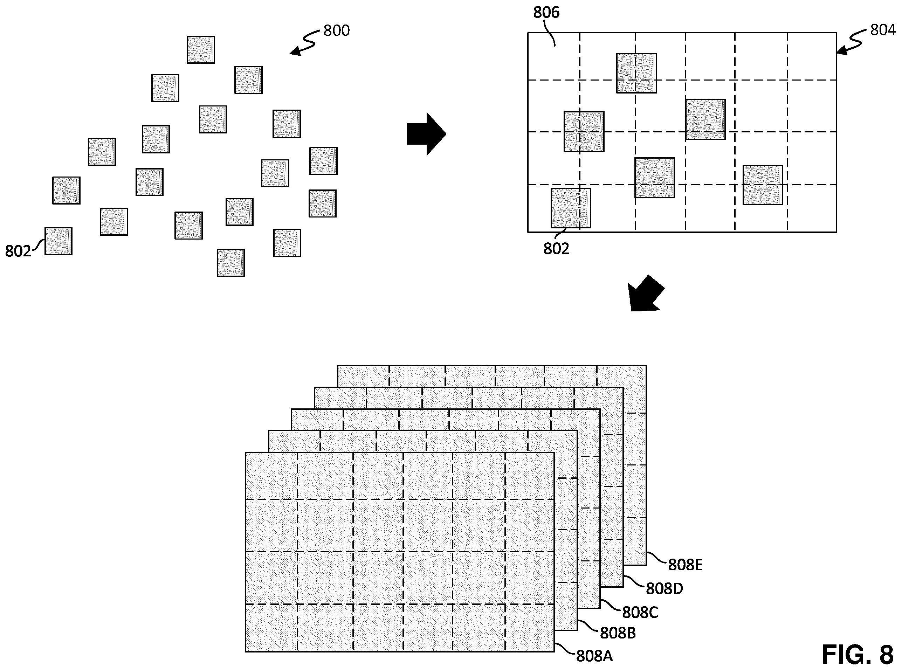

FIG. 8 illustrates generation of a locality preserving hash comprising feature measurements in accordance with any of the embodiments disclosed herein. A pattern 800 of a portion of a layer comprising polygons 802 (e.g., drawn polygons of a mask layer) is depicted. A window 804 is formed around a portion of the pattern (e.g., based on an anchor point of a target segment of a polygon as described above). The window is divided into sections 806. In various embodiments, the sections 806 may have a rectangular shape. In some embodiments, the sections 806 may be sized equally. In this embodiment, the window is divided into four rows and six columns of sections, although other implementations may have different numbers of rows and/or columns.

For each section 806, a series of feature measurements are recorded. In the embodiment depicted, five different feature measurement types are recorded. Accordingly, five data sets 808A-808E are shown, each corresponding to one measurement type for each section 806. In this example, the 4x6x5 measurement collection is considered to be the hash of the window 804. Each section of the window is thus represented in the similarity hash vector. The captured features are referred to as shingles in the field of locality sensitive hashing.

The hash is similar to an image representation of the data, but in an aggregate or summary sense. For example, the hash may be similar to an image with pixels having various components values (e.g., RGB intensity values), where the sections correspond to pixels and the feature measurements correspond to the component values. As such the hash may be particularly amenable to processing by neural networks that process images (as it resembles a 2D image). In other embodiments, the hash may comprise any suitable vector of feature measurements arranged in any suitable order.

In this approach, salient features in portions of the window are captured. The collection of these features, and their relative positions with respect to each other, serve to provide information about the pattern in the window. Small perturbations of the window will typically not change the captured feature set significantly. The hash is fixed in dimension, while the original pattern can have varying dimensions.

Any suitable feature measurements may be included in the hash, such as one or more distances between polygons of the window, one or more widths and/or lengths of one or more polygons of the window, areas of one or more polygons of the window, information about the relative placement of polygons within the window, or other suitable properties associated with the geometry of the polygons of the window.

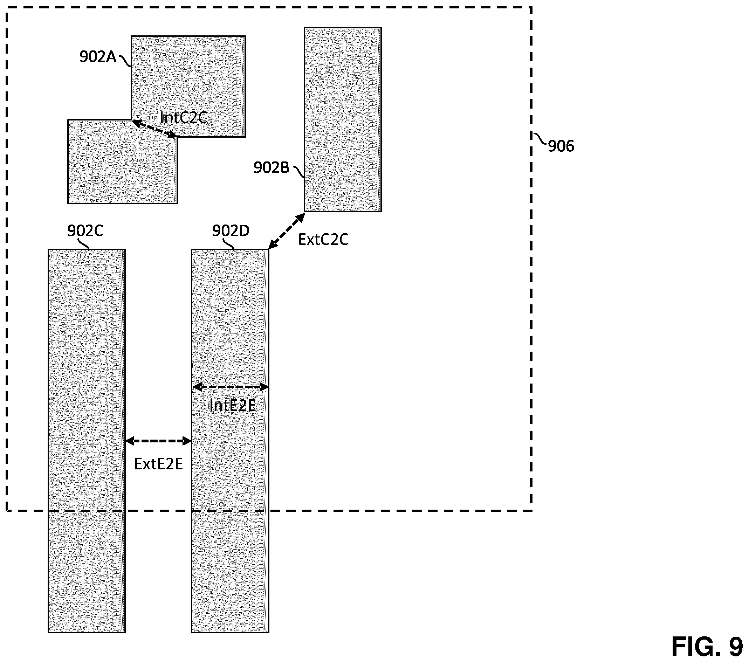

FIG. 9 illustrates example feature measurements in accordance with any of the embodiments disclosed herein. In FIG. 9, a section 906 of a window includes at least a portion of four drawn polygons 902A -902D.

In this example, the feature measurements include an internal corner to corner (IntC2C) measurement, an external corner to corner (ExtC2C) measurement, an internal end to end (IntE2E) measurement, an external end to end (ExtE2E) measurement, and a density measurement. The IntC2C represents the smallest internal corner distance within any polygon that is at least partially within the section, the ExtC2C represents the smallest external corner distance between a polygon that is at least partially within the section and any other polygon that is at least partially within the window, the IntE2E represents the smallest end-to-end distance between edges of a polygon that is at least partially within the section, and the ExtE2E represents the smallest end-to-end distance between an edge of a polygon at least partially within the section and another polygon at least partially within the window. In various embodiments, if a measurement is not applicable, a saturation value may be recorded for the particular measurement. For example, if every polygon within a section is rectangular, it will not have an internal corner to corner measurement. As another example, if a section does not include any polygons then all of the above measurements may be saturated (either to the same value or to a value specific to the measurement type).

In some embodiments, a fifth feature measurement of the hash may be a density (e.g., of a section), which represents a ratio of area covered by one or more polygons within the section. In various instances, the density may be sampled (or calculated in other suitable manner). For example, each section may be divided into a certain number of points (e.g., sixteen points) that are sampled (as to whether they are occupied by a polygon) for the density measurement.

Collection of feature measurements for locality preserving hashes may provide several advantages. For example, locality sensitive searching for semiconductor layout applications is enabled. This may provide for fast queries for similar patterns (e.g., patterns that have certain critical dimension/pitch combinations or corner-to-corner configurations) from a large layout (e.g., billions or trillions) of polygons. As another example, interpolation of OPC patterns from previously encountered patterns may be achieved. As yet another example, the approach scales well from a compute perspective.

As discussed earlier, the locality preserving hashes may be used to predict attribute values for patterns. As used herein, the term hash may encompass the hashes described above as well as processed versions of such hashes (that may then be stored and/or provided as input for a prediction of a pattern attribute).

In some embodiments, a hash may be provided as input to a lookup table with hashes and corresponding pattern attributes. If an exact match between the input hash and a stored hash is found, a pattern attribute may be retrieved and used for the pattern.

In other embodiments, one or more machine learning models are used to predict the attribute values for the patterns. A machine learning model may implement a lossy version of a lookup table and may be capable of generating interpolated pattern attributes for patterns that aren't exact matches to previously encountered patterns.

In general, any suitable ML models may be used to implement various embodiments described herein, e.g., neural networks, variational autoencoders, and/or other suitable architectures. The ML models may be incrementally updated with newer learning (e.g., without requiring re-building everything from scratch responsive to new data). In various embodiments, an open source machine learning library (e.g., Torch, TensorFlow, etc.) is used for development and inference of the ML model. Once the model has been built, one may perform an inference to deduce the final mask; the cost of inference should be much smaller than the rendering of a physical model. This limits the complexity of the ML model architecture being developed. In some instances, the same tool (e.g., in Python) may be used for the training and inference, avoiding a translation of the ML model from training to inference mode (thus avoiding translation errors and numerical approximation errors).

In various embodiments, the various ML architectures that may be used may provide one or more advantages, such as the ability to train arbitrary ML models given pattern data and quantities to predict (such as mask configuration), the ability to update/augment predictive models (rather than re-build models) based on new learning with continuing tapeouts, and the ability to do training and inference at scale (e.g., inference for numerous drawn polygons, such as billions or trillions). In various embodiments, the only bounds on the ML models are inference compute cost as this generally should be less than the physical model rendering to be of compute value. Irrespective of compute cost, the ML model predicting the final outcome helps reduce mask-variability.

In various embodiments, the hashes may be used to build a predictive ML model that is able to predict a mask given a drawn pattern. The ground truth data for the ML model may be data from an OPC process and related tapeout data. For example, the ground truth data may include hashes of patterns and corresponding pattern attributes (e.g., mask segment displacements, yield probabilities, etc.). In various embodiments, the hashes and corresponding pattern attributes may be obtained from a known good design that has undergone an OPC process (and/or has already been manufactured). In some instances, the data from a known good design may include mask patterns with high variability. For example, in the known good design, the same drawn pattern may have resulted in multiple OPC corrected patterns (and thus, different pattern attributes (e.g., mask segment displacements). In such instances, before the data is used to train the ML model, a single pattern attribute (e.g., an average of the various pattern attributes for the various instances of the drawn pattern) may be selected and associated with the drawn pattern. Thus, the hash for the drawn pattern may be associated with the selected pattern attribute and used to train the ML model. When the pattern attribute is a mask segment displacement value, use of the same mask segment displacement value for the various instances of the drawn pattern that corresponds to the hash will reduce the variability in the mask output of the OPC process.

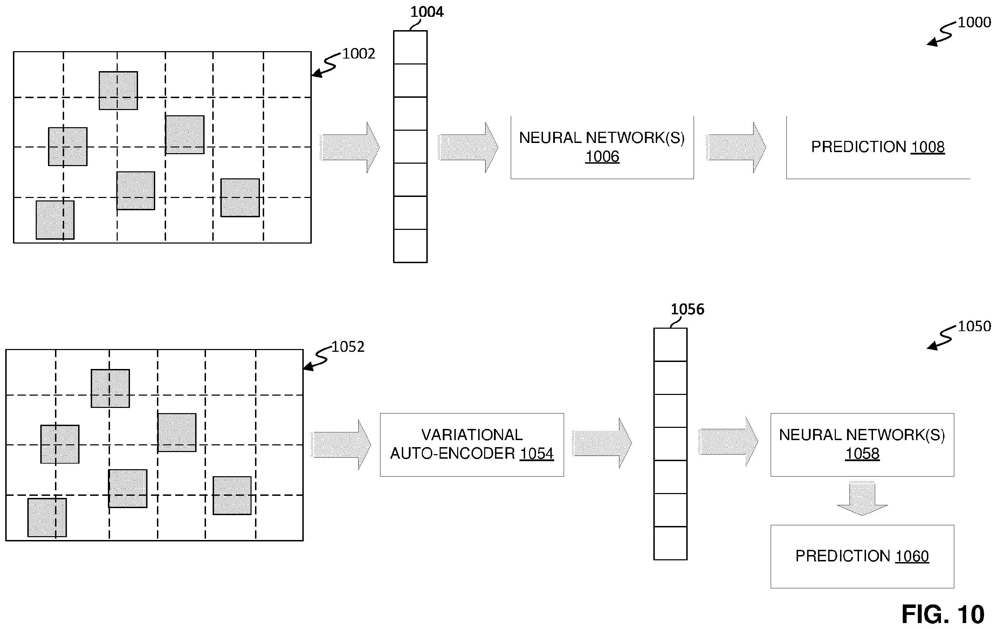

FIG. 10 illustrates two architectures for prediction of a pattern attribute (e.g., a mask segment displacement, a yield probability, etc.) based on a locality preserving hash in accordance with any of the embodiments disclosed herein. In architecture 1000, a window 1002 comprising one or more drawn polygons is analyzed to generate a hash 1004 comprising a series of feature measurements for the sections of the window 1002 (or a series of moments in other embodiments). The hash 1004 is then provided to neural network(s) 1006 which generates a prediction 1008 (e.g., a displacement for a target segment of a polygon within the window 1002).

In various embodiments, neural network(s) 1006 may include a convolutional neural network (CNN) that uses the two dimensional relationships between the sections (e.g., pixels) as part of the ML model as well a deep neural network (DNN) after the CNN to generate the predictions. In this architecture, similarity by construction is assumed, that is, similar input patterns should yield similar summary maps. In some embodiments, decision trees may be used for neural network(s) 1006.

Architecture 1050 is similar to architecture 1000, but also utilizes a variational auto-encoder 1054 to process features measurements of the window 1052 to generate the vector 1056. The vector 1056 is then provided to neural network(s) 1058. The neural network(s) 1058 then generate a prediction 1060. In this instance, ML training is used to generate an encoder that yields a similarity map between summary maps. Symmetry in machine learning may be exploited to auto-develop an encoder that creates vectors that are similar for similar geometries.

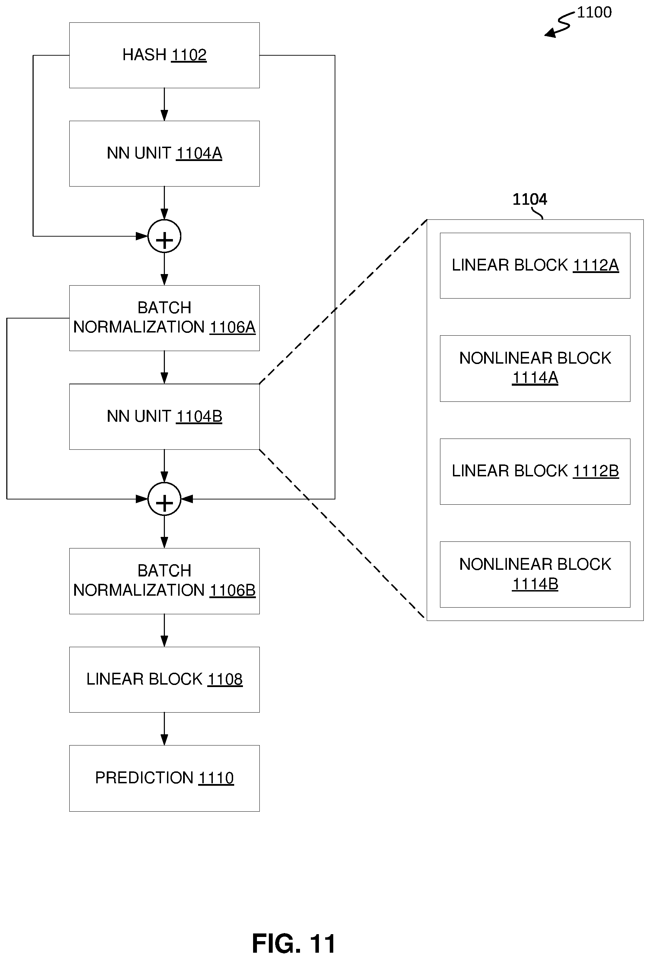

FIG. 11 illustrates a machine learning architecture 1100 for reducing mask variability through locality preserving hashes in accordance with any of the embodiments disclosed herein.

A hash 1102 is provided as input to a neural network unit 1104A. A neural network unit 1104 is a layer of a neural network. In the embodiment depicted, a neural network unit 1104 includes linear blocks 1112 as well as nonlinear blocks 1114 (in one embodiment, the nonlinear blocks may perform a tanh operation).

The architecture further includes batch normalization blocks 1106A and 1106B to normalize values to within a desired range (e.g., -1 to 1) for consumption by a linear block (e.g., 1112A or 1108). Linear block 1108 receives a vector of values and outputs a prediction 1110 (e.g., a scalar number).

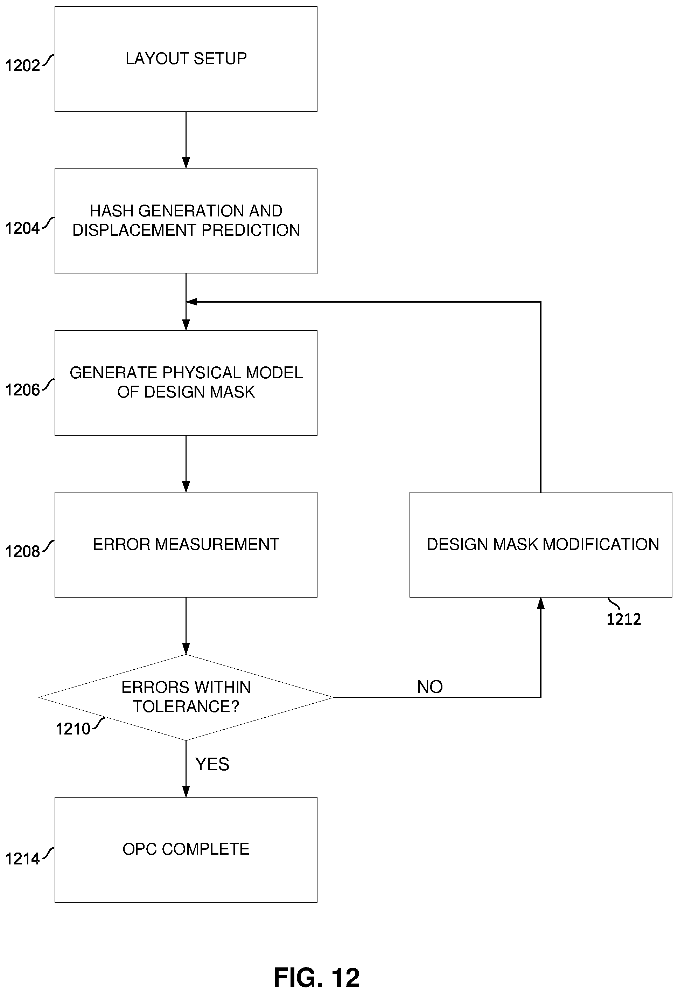

FIG. 12 illustrates a flow for reducing mask variability through locality preserving hashes in accordance with any of the embodiments disclosed herein. At 1202, layout setup is performed. For example, a plurality of polygons of a layer of a semiconductor layout file are divided into segments. At 1204, locality preserving hashes are generated and displacements for segments of polygons of the layout file are predicted based on the hashes (e.g., using any of the techniques described above). The result is effectively a mask layer with modified polygons (similar to the output of an OPC process flow).

After this initial determination of the modified polygons based on the locality preserving hashes, the flow may include additional steps that may generally be included in an OPC process flow. For example, at 1206 a physical model of the design mask is generated (e.g., by performing a high resolution physics simulation). The physical model predicts the shapes (e.g., printed shapes 360) that will be manufactured through use of the design mask.

At 1208, error measurement is performed. During error measurement, differences between the shapes predicted by the physical model and the originally drawn polygons are determined. At 1210, a determination is made as to whether the errors are within an allowed tolerance. If the errors are not within tolerance, the flow moves to 1212 where additional modifications are made to the design mask (e.g., at the locations that generated errors that were not within tolerance). For example, segments of polygons may be moved to reduce the errors. The flow then returns to 1206 for another iteration of physical model generation and error measurement. If the errors are within tolerance at 1210, the OPC process is completed at 1214.

In various embodiments, one or more operations of the flow may be repeated for one or more additional layers of the layout file.

Calculating the hashes and predicting the displacements for the segments of the polygons based thereon may significantly speed up the OPC process flow as these predictions may reduce the number of times that operations 1208, 1210, and 1212 need to be performed (generation of the physical model in particular may be relatively time intensive).

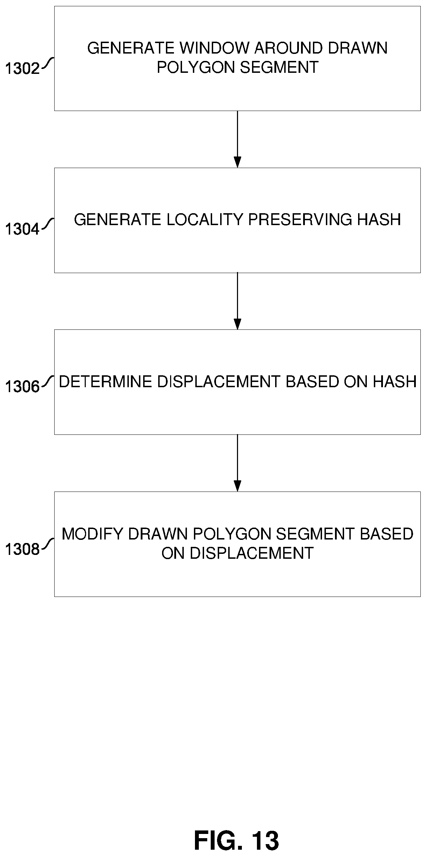

FIG. 13 illustrates a flow for modifying a polygon segment based on a locality preserving hash in accordance with any of the embodiments disclosed herein. At 1302, a window around a drawn polygon segment is generated. At 1304, a locality preserving hash is generated based on the geometry of one or more polygons in the window. At 1306, a displacement for the polygon segment is determined based on the hash. At 1306, the drawn polygon segment is modified based on the determined displacement.

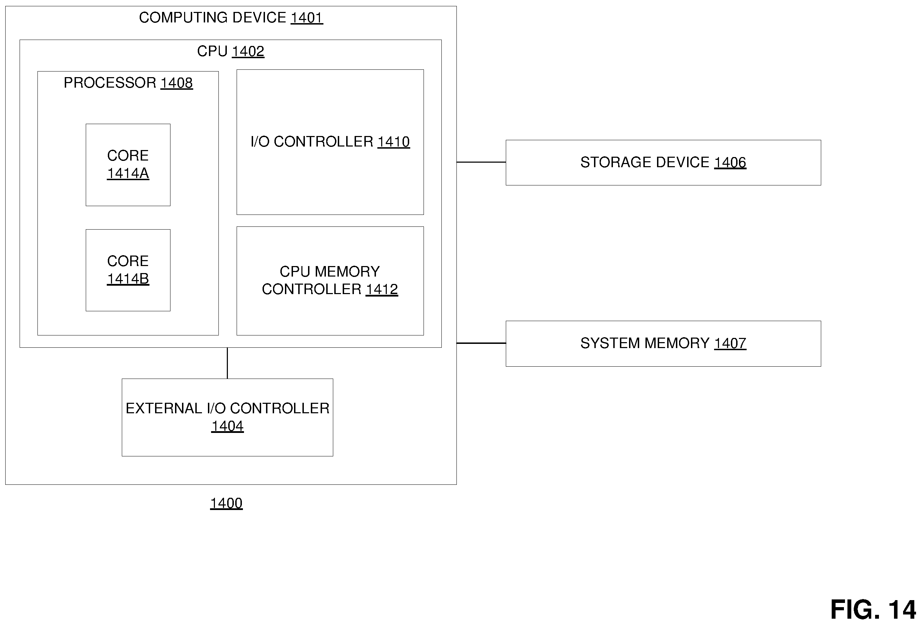

FIG. 14 illustrates a computing system 1400 in accordance with any of the embodiments disclosed herein. Any suitable components of system 1400 may be used to perform any of the operations described herein, e.g., in connection with FIGS. 4-13. For example, a computing system 1400 may implement calculation of locality sensitive hashes and/or determine mask segment displacement based on such hashes.

System 1400 includes a computing device 1401 comprising a central processing unit (CPU) 1402 coupled to an external input/output (I/O) controller 1404, storage device 1406 (which in some embodiments may store locality sensitive hashes in association with pattern attributes), and system memory 1407. Although various components are illustrated, computing system 1400 may include additional other components or multiples of the components illustrated.

During operation, data may be transferred between storage device 1406 or system memory 1407 and the CPU 1402. In various embodiments, particular data operations (e.g., erase, program, and read operations) involving a storage device 1406 or system memory 1407 may be managed by an operating system or other software application executed by processor 1408.

CPU 1402 comprises a processor 1408, such as a microprocessor, an embedded processor, a digital signal processor (DSP), a network processor, a handheld processor, an application processor, a co-processor, a system on a chip (SOC), or other device to execute code (i.e., software instructions). Processor 1408, in the depicted embodiment, includes two processing elements (cores 1414A and 1414B in the depicted embodiment), which may include asymmetric processing elements or symmetric processing elements. However, a processor may include any number of processing elements that may be symmetric or asymmetric.

In one embodiment, a processing element refers to hardware or logic to support a software thread. Examples of hardware processing elements include: a thread unit, a thread slot, a thread, a process unit, a context, a context unit, a logical processor, a hardware thread, a core, and/or any other element, which is capable of holding a state for a processor, such as an execution state or architectural state. In other words, a processing element, in one embodiment, refers to any hardware capable of being independently associated with code, such as a software thread, operating system, application, or other code. A physical processor (or processor socket) typically refers to an integrated circuit, which potentially includes any number of other processing elements, such as cores or hardware threads.

A core 1414 may refer to logic located on an integrated circuit capable of maintaining an independent architectural state, wherein each independently maintained architectural state is associated with at least some dedicated execution resources. A hardware thread may refer to any logic located on an integrated circuit capable of maintaining an independent architectural state, wherein the independently maintained architectural states share access to execution resources. As can be seen, when certain resources are shared and others are dedicated to an architectural state, the line between the nomenclature of a hardware thread and core overlaps. Yet often, a core and a hardware thread are viewed by an operating system as individual logical processors, where the operating system is able to individually schedule operations on each logical processor.

In various embodiments, the processing elements may also include one or more arithmetic logic units (ALUs), floating point units (FPUs), caches, instruction pipelines, interrupt handling hardware, registers, or other hardware to facilitate the operations of the processing elements.

I/O controller 1410 is an integrated I/O controller. I/O controller 1410 may include logic for communicating data between CPU 1402 and I/O devices, which may refer to any suitable devices capable of transferring data to and/or receiving data from an electronic system, such as CPU 1402. For example, an I/O device may comprise an audio/video (A/V) device controller such as a graphics accelerator or audio controller; a data storage device controller, such as a flash memory device, magnetic storage disk, or optical storage disk controller; a wireless transceiver; a network processor; a network interface controller; or a controller for another input devices such as a monitor, printer, mouse, keyboard, or scanner; or other suitable device. In a particular embodiment, an I/O device may comprise a storage device 1406 that may be coupled to the CPU 1402 through I/O controller 1410.

An I/O device may communicate with the I/O controller 1410 of the CPU 1402 using any suitable signaling protocol, such as peripheral component interconnect (PCI), PCI Express (PCIe), Universal Serial Bus (USB), Serial Attached SCSI (SAS), Serial ATA (SATA), Fibre Channel (FC), IEEE 802.3, IEEE 802.11, or other current or future signaling protocol. In particular embodiments, I/O controller 1410 and the underlying I/O device may communicate data and commands in accordance with a logical device interface specification such as Non-Volatile Memory Express (NVMe) (e.g., as described by one or more of the specifications available at www.nvmexpress.org/specifications/) or Advanced Host Controller Interface (AHCI) (e.g., as described by one or more AHCI specifications such as Serial ATA AHCI: Specification, Rev. 1.3.1 available at http://www.intel.com/content/www/us/en/io/serial-ata/serial-ata-ahci-spec-rev1-3-1.html). In various embodiments, I/O devices coupled to the I/O controller may be located off-chip (i.e., not on the same chip as CPU 1402) or may be integrated on the same chip as the CPU 1402.

CPU memory controller 1412 is an integrated memory controller. CPU memory controller may include logic to control the flow of data going to and from one or more system memories 1407. CPU memory controller 1412 may include logic operable to read from a system memory 1407, write to a system memory 1407, or to request other operations from a system memory 1407. In various embodiments, CPU memory controller 1412 may receive write requests from cores 1414 and/or I/O controller 1410 and may provide data specified in these requests to a system memory 1407 for storage therein. CPU memory controller 1412 may also read data from a system memory 1407 and provide the read data to I/O controller 1410 or a core 1414. During operation, CPU memory controller 1412 may issue commands including one or more addresses of the system memory 1407 in order to read data from or write data to memory (or to perform other operations). In some embodiments, CPU memory controller 1412 may be implemented on the same chip as CPU 1402, whereas in other embodiments, CPU memory controller 1412 may be implemented on a different chip than that of CPU 1402. I/O controller 1410 may perform similar operations with respect to one or more storage devices 1406.

The CPU 1402 may also be coupled to one or more other I/O devices through external I/O controller 1404. In a particular embodiment, external I/O controller 1404 may couple a storage device 1406 to the CPU 1402. External I/O controller 1404 may include logic to manage the flow of data between one or more CPUs 1402 and I/O devices. In particular embodiments, external I/O controller 1404 is located on a motherboard along with the CPU 1402. The external I/O controller 1404 may exchange information with components of CPU 1402 using point-to-point or other interfaces. In various embodiments, external I/O controller 1404 may include any one or more characteristics of memory controller 1410.

A system memory 1407 may store any suitable data, such as data used by processor 1408 to provide the functionality of computer system 1400. For example, data associated with programs that are executed or files accessed by cores 1414 may be stored in system memory 1407. Thus, a system memory 1407 may include a system memory that stores data and/or sequences of instructions that are executed or otherwise used by the cores 1414. In various embodiments, a system memory 1407 may store persistent data (e.g., a user's files or instruction sequences) that remains stored even after power to the system memory 1407 is removed. A system memory 1407 may be dedicated to a particular CPU 1402 or shared with other devices (e.g., one or more other processors or other devices) of computer system 1400.

In various embodiments, a system memory 1407 may include a memory comprising any number of memory arrays, a memory device controller (In various embodiments, the memory device controller may include any one or more characteristics of memory controller 1410), and other supporting logic (not shown). A memory array may include non-volatile memory and/or volatile memory. Non-volatile memory is a storage medium that does not require power to maintain the state of data stored by the medium. Nonlimiting examples of nonvolatile memory may include any or a combination of: solid state memory (such as planar or 3D NAND flash memory or NOR flash memory), 3D crosspoint memory, memory devices that use chalcogenide phase change material (e.g., chalcogenide glass), byte addressable nonvolatile memory devices, ferroelectric memory, silicon-oxide-nitride-oxide-silicon (SONOS) memory, polymer memory (e.g., ferroelectric polymer memory), ferroelectric transistor random access memory (Fe-TRAM) ovonic memory, nanowire memory, electrically erasable programmable read-only memory (EEPROM), other various types of non-volatile random access memories (RAMs), and magnetic storage memory. In some embodiments, 3D crosspoint memory may comprise a transistor-less stackable cross point architecture in which memory cells sit at the intersection of words lines and bit lines and are individually addressable and in which bit storage is based on a change in bulk resistance. Volatile memory is a storage medium that requires power to maintain the state of data stored by the medium. Examples of volatile memory may include various types of random access memory (RAM), such as dynamic random-access memory (DRAM) or static random-access memory (SRAM). One particular type of DRAM that may be used in a memory array is synchronous dynamic random-access memory (SDRAM). In some embodiments, any portion of memory 1407 that is volatile memory can comply with JEDEC standards including but not limited to Double Data Rate (DDR) standards, e.g., DDR3, 4, and 5, or Low Power DDR4 (LPDDR4) as well as emerging standards.

A storage device 1406 may store any suitable data, such as data used by processor 1408 to provide functionality of computer system 1400. For example, data associated with programs that are executed or files accessed by cores 1414A and 1414B may be stored in storage device 1406. Thus, in some embodiments, a storage device 1406 may store data and/or sequences of instructions that are executed or otherwise used by the cores 1414A and 1414B. In various embodiments, a storage device 1406 may store persistent data (e.g., a user's files or software application code) that remains stored even after power to the storage device 1406 is removed. A storage device 1406 may be dedicated to CPU 1402 or shared with other devices (e.g., another CPU or other device) of computer system 1400.

In various embodiments, storage device 1406 includes a storage device controller and one or more memory modules. In various embodiments, a memory module of storage device 1406 comprises one or more NAND flash memory arrays, one or more hard disk drives, or other suitable memory storage devices. Storage device 1406 may comprise any suitable type of memory and is not limited to a particular speed, technology, or form factor of memory in various embodiments. For example, a storage device 1406 may be a disk drive (such as a solid-state drive), a flash drive, memory integrated with a computing device (e.g., memory integrated on a circuit board of the computing device), a memory module (e.g., a dual in-line memory module) that may be inserted in a memory socket, or other type of storage device. Moreover, computer system 1400 may include multiple different types of storage devices. Storage device 1406 may include any suitable interface to communicate with CPU memory controller 1412 or I/O controller 1410 using any suitable communication protocol such as a DDR-based protocol, PCI, PCIe, USB, SAS, SATA, FC, System Management Bus (SMBus), or other suitable protocol. A storage device 1406 may also include a communication interface to communicate with CPU memory controller 1412 or I/O controller 1410 in accordance with any suitable logical device interface specification such as NVMe, AHCI, or other suitable specification. In particular embodiments, storage device 1406 may comprise multiple communication interfaces that each communicate using a separate protocol with CPU memory controller 1412 and/or I/O controller 1410.

In some embodiments, all, or some of the elements of system 1400 are resident on (or coupled to) the same circuit board (e.g., a motherboard). In various embodiments, any suitable partitioning between the elements may exist. For example, the elements depicted in CPU 1402 may be located on a single die (i.e., on-chip) or package or any of the elements of CPU 1402 may be located off-chip or off-package. Similarly, the elements depicted in storage device 1406 may be located on a single chip or on multiple chips. In various embodiments, a storage device 1406 and a computing device (e.g., CPU 1402) may be located on the same circuit board or on the same device and in other embodiments the storage device 1406 and the computing device may be located on different circuit boards or devices.

The components of system 1400 may be coupled together in any suitable manner. For example, a bus may couple any of the components together. A bus may include any known interconnect, such as a multi-drop bus, a mesh interconnect, a ring interconnect, a point-to-point interconnect, a serial interconnect, a parallel bus, a coherent (e.g. cache coherent) bus, a layered protocol architecture, a differential bus, and a Gunning transceiver logic (GTL) bus. In various embodiments, an integrated I/O subsystem includes point-to-point multiplexing logic between various components of system 1400, such as cores 1414, one or more CPU memory controllers 1412, I/O controller 1410, integrated I/O devices, direct memory access (DMA) logic (not shown), etc. In various embodiments, components of computer system 1400 may be coupled together through one or more networks comprising any number of intervening network nodes, such as routers, switches, or other computing devices. For example, a computing device (e.g., CPU 1402) and the storage device 1406 may be communicably coupled through a network.

Although not depicted, system 1400 may use a battery and/or power supply outlet connector and associated system to receive power, a display to output data provided by CPU 1402, or a network interface allowing the CPU 1402 to communicate over a network. In various embodiments, the battery, power supply outlet connector, display, and/or network interface may be communicatively coupled to CPU 1402. Other sources of power can be used such as renewable energy (e.g., solar power or motion based power).

A design may go through various stages, from creation to simulation to fabrication. Data representing a design may represent the design in a number of manners. First, as is useful in simulations, the hardware may be represented using a hardware description language (HDL) or another functional description language. Additionally, a circuit level model with logic and/or transistor gates may be produced at some stages of the design process. Furthermore, most designs, at some stage, reach a level of data representing the physical placement of various devices in the hardware model. In the case where conventional semiconductor fabrication techniques are used, the data representing the hardware model may be the data specifying the presence or absence of various features on different mask layers for masks used to produce the integrated circuit. In some implementations, such data may be stored in a database file format such as Graphic Data System II (GDS II), Open Artwork System Interchange Standard (OASIS), or similar format.

In some implementations, software based hardware models, and HDL and other functional description language objects can include register transfer language (RTL) files, among other examples. Such objects can be machine-parsable such that a design tool can accept the HDL object (or model), parse the HDL object for attributes of the described hardware, and determine a physical circuit and/or on-chip layout from the object. The output of the design tool can be used to manufacture the physical device. For instance, a design tool can determine configurations of various hardware and/or firmware elements from the HDL object, such as bus widths, registers (including sizes and types), memory blocks, physical link paths, fabric topologies, among other attributes that would be implemented in order to realize the system modeled in the HDL object. Design tools can include tools for determining the topology and fabric configurations of system on chip (SoC) and other hardware device. In some instances, the HDL object can be used as the basis for developing models and design files that can be used by manufacturing equipment to manufacture the described hardware. Indeed, an HDL object itself can be provided as an input to manufacturing system software to cause the described hardware.

In any representation of the design, the data may be stored in any form of a machine readable medium. A memory or a magnetic or optical storage such as a disc may be the machine readable medium to store information transmitted via optical or electrical wave modulated or otherwise generated to transmit such information. When an electrical carrier wave indicating or carrying the code or design is transmitted, to the extent that copying, buffering, or re-transmission of the electrical signal is performed, a new copy is made. Thus, a communication provider or a network provider may store on a tangible, machine-readable medium, at least temporarily, an article, such as information encoded into a carrier wave, embodying techniques of embodiments of the present disclosure.

In various embodiments, a medium storing a representation of the design may be provided to a manufacturing system (e.g., a semiconductor manufacturing system capable of manufacturing an integrated circuit and/or related components). The design representation may instruct the system to manufacture a device capable of performing any combination of the functions described above. For example, the design representation may instruct the system regarding which components to manufacture, how the components should be coupled together, where the components should be placed on the device, and/or regarding other suitable specifications regarding the device to be manufactured.

Various components described herein may be implemented as modules. A module as used herein refers to circuitry and any combination of hardware, software, and/or firmware. As an example, a module includes hardware, such as a micro-controller, associated with a non-transitory medium to store code adapted to be executed by the micro-controller. Therefore, reference to a module, in one embodiment, refers to the hardware, which is specifically configured to recognize and/or execute the code to be held on a non-transitory medium. Furthermore, in another embodiment, use of a module refers to the non-transitory medium including the code, which is specifically adapted to be executed by the microcontroller to perform predetermined operations. And as can be inferred, in yet another embodiment, the term module (in this example) may refer to the combination of the microcontroller and the non-transitory medium. Often module boundaries that are illustrated as separate commonly vary and potentially overlap. For example, a first and a second module may share hardware, software, firmware, or a combination thereof, while potentially retaining some independent hardware, software, or firmware. In one embodiment, use of the term logic includes hardware, such as transistors, registers, or other hardware, such as programmable logic devices. The description of modules above may also apply to other similar entities, such as blocks or units.

Logic may be used to implement any of the flows described or functionality of the various components described herein. "Logic" may refer to hardware, firmware, software and/or combinations of each to perform one or more functions. In various embodiments, logic may include a microprocessor or other processing element operable to execute software instructions, discrete logic such as an application specific integrated circuit (ASIC), a programmed logic device such as a field programmable gate array (FPGA), a storage device containing instructions, combinations of logic devices (e.g., as would be found on a printed circuit board), or other suitable hardware and/or software. Logic may include one or more gates or other circuit components. In some embodiments, logic may also be fully embodied as software. Software may be embodied as a software package, code, instructions, instruction sets and/or data recorded on non-transitory computer readable storage medium. Firmware may be embodied as code, instructions or instruction sets and/or data that are hard-coded (e.g., nonvolatile) in storage devices.

Use of the phrase 'to' or 'configured to,' in one embodiment, refers to arranging, putting together, manufacturing, offering to sell, importing, and/or designing an apparatus, hardware, logic, or element to perform a designated or determined task. In this example, an apparatus or element thereof that is not operating is still 'configured to' perform a designated task if it is designed, coupled, and/or interconnected to perform said designated task. As a purely illustrative example, a logic gate may provide a 0 or a 1 during operation. But a logic gate 'configured to' provide an enable signal to a clock does not include every potential logic gate that may provide a 1 or 0. Instead, the logic gate is one coupled in some manner that during operation the 1 or 0 output is to enable the clock. Note once again that use of the term 'configured to' does not require operation, but instead focus on the latent state of an apparatus, hardware, and/or element, where in the latent state the apparatus, hardware, and/or element is designed to perform a particular task when the apparatus, hardware, and/or element is operating.

Furthermore, use of the phrases 'capable of/to,' and or 'operable to,' in one embodiment, refers to some apparatus, logic, hardware, and/or element designed in such a way to enable use of the apparatus, logic, hardware, and/or element in a specified manner. Note as above that use of to, capable to, or operable to, in one embodiment, refers to the latent state of an apparatus, logic, hardware, and/or element, where the apparatus, logic, hardware, and/or element is not operating but is designed in such a manner to enable use of an apparatus in a specified manner.

A value, as used herein, includes any known representation of a number, a state, a logical state, or a binary logical state. Often, the use of logic levels, logic values, or logical values is also referred to as 1's and 0's, which simply represents binary logic states. For example, a 1 refers to a high logic level and 0 refers to a low logic level. In one embodiment, a storage cell, such as a transistor or flash cell, may be capable of holding a single logical value or multiple logical values. However, other representations of values in computer systems have been used. For example, the decimal number ten may also be represented as a binary value of 1010 and a hexadecimal letter A. Therefore, a value includes any representation of information capable of being held in a computer system.

Moreover, states may be represented by values or portions of values. As an example, a first value, such as a logical one, may represent a default or initial state, while a second value, such as a logical zero, may represent a non-default state. In addition, the terms reset and set, in one embodiment, refer to a default and an updated value or state, respectively. For example, a default value potentially includes a high logical value, i.e. reset, while an updated value potentially includes a low logical value, i.e. set. Note that any combination of values may be utilized to represent any number of states.

The embodiments of methods, hardware, software, firmware or code set forth above may be implemented via instructions or code stored on a machine-accessible, machine readable, computer accessible, or computer readable medium which are executable by a processing element. A non-transitory machine-accessible/readable medium includes any mechanism that provides (i.e., stores and/or transmits) information in a form readable by a machine, such as a computer or electronic system. For example, a non-transitory machine-accessible medium includes random-access memory (RAM), such as static RAM (SRAM) or dynamic RAM (DRAM); ROM; magnetic or optical storage medium; flash storage devices; electrical storage devices; optical storage devices; acoustical storage devices; other form of storage devices for holding information received from transitory (propagated) signals (e.g., carrier waves, infrared signals, digital signals); etc., which are to be distinguished from the non-transitory mediums that may receive information there from.

Instructions used to program logic to perform embodiments of the disclosure may be stored within a memory in the system, such as DRAM, cache, flash memory, or other storage. Furthermore, the instructions can be distributed via a network or by way of other computer readable media. Thus a machine-readable medium may include any mechanism for storing or transmitting information in a form readable by a machine (e.g., a computer), but is not limited to, floppy diskettes, optical disks, Compact Disc, Read-Only Memory (CD-ROMs), and magneto-optical disks, Read-Only Memory (ROMs), Random Access Memory (RAM), Erasable Programmable Read-Only Memory (EPROM), Electrically Erasable Programmable Read-Only Memory (EEPROM), magnetic or optical cards, flash memory, or a tangible, machine-readable storage used in the transmission of information over the Internet via electrical, optical, acoustical or other forms of propagated signals (e.g., carrier waves, infrared signals, digital signals, etc.). Accordingly, the computer-readable medium includes any type of tangible machine-readable medium suitable for storing or transmitting electronic instructions or information in a form readable by a machine (e.g., a computer).

The following examples pertain to embodiments in accordance with this Specification.

Example 1 includes a medium having instructions stored thereon, the instructions when executed by a machine to cause the machine to generate a hash comprising a plurality of values based on a geometric pattern within a window that represents a portion of a physical design for a semiconductor mask layer, the window including at least a portion of a polygon; determine a displacement value for a segment of the polygon based on the hash; and modify a position of the segment of the polygon based on the displacement value.

Example 2 includes the subject matter of Example 1, and wherein the window is centered around a portion of the segment of the polygon.

Example 3 includes the subject matter of any of Examples 1 and 2, and wherein the hash comprises a plurality of moments.

Example 4 includes the subject matter of any of Examples 1-3, and wherein the moments are calculated based at least in part on a plurality of point masses representing a geometry of the polygon.

Example 5 includes the subject matter of any of Examples 1-4, and wherein the hash comprises a plurality of feature measurements for a plurality of polygons at least partially within the window.

Example 6 includes the subject matter of any of Examples 1-5, and wherein the feature measurements include at least one of a polygon density, a smallest internal corner to corner measurement of the polygon, a worst case external corner to corner measurement of multiple polygons, a worst case internal end to end measurement of the polygon, or a worst case external end to end measurement of multiple polygons.

Example 7 includes the subject matter of any of Examples 1-6, and wherein the window includes a plurality of sections, and the hash includes a plurality of feature measurements for each section of the window.

Example 8 includes the subject matter of any of Examples 1-7, and wherein the instructions when executed by a machine are to cause the machine to predict a yield of the pattern based on the hash.

Example 9 includes the subject matter of any of Examples 1-8, and wherein the instructions when executed by a machine are to cause the machine to execute a machine learning model trained on data from at least one layout database file comprising representations of polygons modified using an optical proximity correction process.

Example 10 includes the subject matter of any of Examples 1-9, wherein the instructions when executed by a machine are to cause the machine to further modify the position of the segment responsive to a determination that the polygon is not within an error tolerance.

Example 11 includes a method comprising forming a window around a target segment of a polygon of a semiconductor layout database file; generating a hash from a pattern of polygons within the window; determining a displacement value for the target segment of the polygon based on the hash; and modifying a position of the target segment of the polygon based on the displacement value.

Example 12 includes the subject matter of Example 11, and wherein the window is centered around a portion of the segment of the polygon.

Example 13 includes the subject matter of any of Examples 11 and 12, and wherein the hash comprises a plurality of moments calculated based on geometries of polygons within the window.

Example 14 includes the subject matter of any of Examples 11-13, and wherein the hash comprises a plurality of moments calculated based at least in part on a plurality of point masses representing a geometry of the polygon.

Example 15 includes the subject matter of any of Examples 11-14, and wherein the hash comprises a plurality of measurements of features of the pattern of polygons within the window.

Example 16 includes the subject matter of any of Examples 11-15, and wherein the hash comprises a plurality of measurements of features of the pattern of polygons within the window, wherein the feature measurements include at least one of a polygon density, a smallest internal corner to corner measurement of the polygon, a worst case external corner to corner measurement of multiple polygons, a worst case internal end to end measurement of the polygon, or a worst case external end to end measurement of multiple polygons.

Example 17 includes the subject matter of any of Examples 11-16, and wherein the window includes a plurality of sections, and the hash includes a plurality of feature measurements for each section of the window.

Example 18 includes the subject matter of any of Examples 11-17, and further including predicting a yield of the pattern based on the hash.

Example 19 includes the subject matter of any of Examples 11-18, and further including training a machine learning model to predict displacement values of segments based on input hashes.

Example 20 includes the subject matter of any of Examples 11-19, and further including executing a machine learning model trained on data from at least one layout database file comprising representations of polygons modified using an optical proximity correction process.

Example 21 includes the subject matter of any of Examples 11-20, and further including further modifying the position of the target segment responsive to a determination that the polygon is not within an error tolerance.

Example 22 includes an apparatus comprising a memory to store a semiconductor layout database file; and a processor coupled to the memory, the processor to form a window around a target segment of a polygon of the semiconductor layout database file; generate a hash comprising a vector of values based on a geometric pattern within the window; determine a displacement value for the target segment based on the hash; and modify a position of the target segment based on the displacement value.

Example 23 includes the subject matter of Example 22, and wherein the window is centered around a portion of the segment of the polygon.

Example 24 includes the subject matter of any of Examples 22 and 23, and wherein the window is centered around a portion of the segment of the polygon.

Example 25 includes the subject matter of any of Examples 22-24, and wherein the hash comprises a plurality of moments, wherein the moments are calculated based at least in part on a plurality of point masses representing a geometry of the polygon.

Example 26 includes the subject matter of any of Examples 22-25, and wherein the hash comprises a plurality of moments calculated based on geometries of polygons within the window.

Example 27 includes the subject matter of any of Examples 22-26, and wherein the hash comprises a plurality of measurements of features of polygons within the window.

Example 28 includes the subject matter of any of Examples 22-27, and wherein the hash comprises a plurality of measurements of features of polygons within the window, wherein the feature measurements include at least one of a polygon density, a smallest internal corner to corner measurement of the polygon, a worst case external corner to corner measurement of multiple polygons, a worst case internal end to end measurement of the polygon, or a worst case external end to end measurement of multiple polygons.

Example 29 includes the subject matter of any of Examples 22-28, and wherein the window includes a plurality of sections, and the hash includes a plurality of feature measurements for each section of the window.

Example 30 includes the subject matter of any of Examples 22-29, and wherein the processor is to further modify the position of the target segment responsive to a determination that the polygon is not within an error tolerance.

Example 31 includes the subject matter of any of Examples 22-30, and wherein the processor is to predict a yield of the pattern based on the hash.

Example 32 includes the subject matter of any of Examples 22-31, and wherein the processor is to execute a machine learning model trained on data from at least one layout database file comprising representations of polygons modified using an optical proximity correction process.

Example 33 includes the subject matter of any of Examples 22-32, and further including one or more of a battery communicatively coupled to the processor, a display communicatively coupled to the processor, or a network interface communicatively coupled to the processor.

Reference throughout this specification to "one embodiment" or "an embodiment" means that a particular feature, structure, or characteristic described in connection with the embodiment is included in at least one embodiment of the present disclosure. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

In the foregoing specification, a detailed description has been given with reference to specific exemplary embodiments. It will, however, be evident that various modifications and changes may be made thereto without departing from the broader scope of the disclosure as set forth in the appended claims. The specification and drawings are, accordingly, to be regarded in an illustrative sense rather than a restrictive sense. Furthermore, the foregoing use of embodiment and other exemplarily language does not necessarily refer to the same embodiment or the same example, but may refer to different and distinct embodiments, as well as potentially the same embodiment.

## Claims

1. A method comprising:
forming a window around a target segment of a polygon of a semiconductor layout database file;
generating a hash from a pattern of polygons within the window;
determining a displacement value for the target segment of the polygon based on the hash; and
modifying a position of the target segment of the polygon based on the displacement value.

2. The method of claim 1, wherein the hash comprises a plurality of moments calculated based on geometries of polygons within the window.

3. The method of claim 2, wherein the plurality of moments are calculated based at least in part on a plurality of point masses representing a geometry of the polygon.

4. The method of claim 1, wherein the hash comprises a plurality of measurements of features of the pattern of polygons within the window.

5. The method of claim 1, further comprising training a machine learning model to predict displacement values of segments based on input hashes.

6. The method of claim 1, further comprising further modifying the position of the target segment responsive to a determination that the polygon is not within an error tolerance.

7. The method of claim 1, wherein the window is centered around a portion of the segment of the polygon.

8. The method of claim 1, wherein the hash comprises a plurality of feature measurements for a plurality of polygons at least partially within the window.

9. The method of claim 8, wherein the feature measurements include at least one of a polygon density, a smallest internal corner to corner measurement of the polygon, a worst case external corner to corner measurement of multiple polygons, a worst case internal end to end measurement of the polygon, or a worst case external end to end measurement of multiple polygons.

10. The method of claim 1, wherein the window includes a plurality of sections, and the hash includes a plurality of feature measurements for each section of the window.

11. The method of claim 1, further comprising predicting a yield of the pattern based on the hash.

12. The method of claim 1, further comprising executing a machine learning model trained on data from at least one layout database file comprising representations of polygons modified using an optical proximity correction process.

13. An apparatus comprising means for performing the method of any of claims 1-12.

14. A computer readable medium including instructions, when executed, to perform the method of any of claims 1-12.

15. An apparatus comprising logic, at least a portion of which is in hardware logic, the logic to perform the method of any of claims 1-12.
